# EUROPÄISCHE PATENTANMELDUNG

(11) **EP 1 294 021 A1**
(43) Veröffentlichungstag der Anmeldung: **19.03.2003**
(21) Anmeldenummer: 01121010.1
(22) Anmeldetag: 31.08.2001
(51) Int. Cl.: H01L 21/8242

(54) **Kondensatoreinrichtung für eine Halbleiterschaltungsanordnung und Verfahren zu deren Herstellung**

(71) Anmelder: Infineon Technologies AG, 81669 München (DE)
(72) Erfinder: Hecht, Thomas, 01099 Dresden (DE); Seidl, Harald, 01099 Dresden (DE)
(74) Vertreter: Müller - Hoffmann & Partner

(57) **Zusammenfassung**

Um bei gesteigerter Integrationsdichte Kondensatoren (40) für Halbleiterschaltungsanordnungen mit gleichbleibender oder erhöhter Kapazität gewährleisten zu können, ist vorgesehen, erste und/oder zweite Elektrodenbereiche (44, 48) aus einem metallischen Material, einem Metallnitrid oder dergleichen auszubilden. Zusätzlich oder alternativ kann ein zwischen den Elektrodenbereichen (44, 48) gelegener Dielektrikumsbereich (46) mit einem Material mit gesteigerter Dielektrizitätskonstante ausgebildet werden.

## Beschreibung

Kondensatoreinrichtung für eine Halbleiterschaltungsanordnung und Verfahren zu deren Herstellung

Die Erfindung betrifft eine Kondensatoreinrichtung für eine Halbleiterschaltungsanordnung sowie ein Verfahren zu deren Herstellung.

Ein Hauptaspekt bei der Fortentwicklung moderner Halbleiterschaltungsanordnungen und insbesondere -speichertechnologien ist die Steigerung der Integrationsdichte. Dabei wird versucht, die Anzahl pro Flächeneinheit in einem Halbleitersubstrat oder dergleichen auszubildender Schaltelemente oder Speicherzellen zu steigern, um möglichst kleine, kompakte und leistungsfähige Schaltungen, insbesondere Halbleiterspeicher, erreichen zu können.

Bei vielen Halbleiterschaltungsanordnungen sind Kondensatoranordnungen notwendig, zum Beispiel auch als Speicherkondensatoren oder dergleichen. Diese Kondensatoranordnungen werden oft in Form von sogenannten Trenchkondensatoren (Trench Capacitor)oder Grabenstrukturkondensatoren oder in Form von Stapelkondensatoren (Stacked Capacitor) ausgebildet. In dynamischen Schreib-/Lesepeichern, z.B. vom DRAM-Typ werden derartige Kondensatoranordnungen z.B. in Ein-Transistor-Zellen als Speicherelement eingesetzt, wobei ein sogenannter Auswahltransistor den Speicherkondensator mit einer Bitleitung verbindet.

Ganz allgemein sind der strukturelle Aufbau und die Herstellung von Kondensatorstrukturen oder Kondensatoranordnungen problematisch und von Interesse, wenn die Integrationsdichte gesteigert werden soll. Dabei soll vorangehend und nachfolgend unter einer Kondensatorstruktur oder einer Kondensatoranordnung ganz allgemein eine Anordnung aus einem ersten, als Elektrodenbereich dienenden Materialbereich in im Wesentlichen direkter räumlicher Nachbarschaft mit einem zweiten, als Dielektrikumsbereich dienenden Materialbereich verstanden werden.

Die Erfindung befasst sich also ganz allgemein mit der Fortbildung der Struktur dieser Materialanordnungen aus Elektrode und Dielektrikum. Dabei sind eine Gegenelektrode oder ein zweiter Elektrodenbereich unter Umständen nicht explizit vorzusehen, sondern können sich gegebenenfalls auch implizit oder inhärent als "Masse" ergeben.

Bei bekannten Kondensatoreinrichtungen oder dergleichen, insbesondere für eine Halbleiterspeichereinrichtung, einen DRAM-Speicher oder dergleichen wird z.B. in einem Halbleitersubstrat, einem Passivierungsbereich und/oder einem Oberflächenbereich davon, eine mindestens eine Ausnehmung oder einen Graben aufweisende Grabenstruktur ausgebildet. Ferner wird dabei zumindest im Bereich des Grabens eine Anordnung mit einer ersten Elektrode oder einem ersten Elektrodenbereich, einer zweiten Elektrode oder einem zweiten Elektrodenbereich und einem im Wesentlichen dazwischen vorgesehenen Dielektrikumsbereich, insbesondere in dieser Reihenfolge, in jeweils im Wesentlichen zusammenhängender Form ausgebildet, wobei zumindest Wandbereiche oder Randbereiche und/oder Bodenbereiche des jeweiligen Grabens im Wesentlichen bedeckt und/oder ausgekleidet werden. Durch die Anordnung der Elektrodenbereiche mit dem dazwischen vorgesehenen Dielektrikum wird dann jeweils gerade die entsprechende Kondensatoreinrichtung gebildet.

Aufgrund der Ansprüche im Hinblick auf die gesteigerte Integration bekannter Halbleiterspeichereinrichtungen müssen in Folge auch die entsprechenden Kondensatoreinrichtungen weiter miniaturisiert werden. Für eine zulässige Funktionsweise derartiger Kondensatoreinrichtungen ist aber das Bereitstellen einer bestimmten Mindestkapazität unerlässlich. Da die Kondensatorkapazität aber - insbesondere bei ansonsten konstanten Parametern - streng mit der Flächendimensionierung der Kondensatoreinrichtung korreliert ist, ist zum Erzielen einer Mindestkapazität entsprechend auch eine Mindestgröße, also eine minimale Ausdehnung der sich gegenüberstehenden Elektrodenbereiche mit dem dazwischen liegenden Dielektrikumsbereich notwendig. Das Einhalten einer Mindestgröße widerspricht aber maßgeblich dem Wunsch, die Integrationsdichte bei Halbleiterspeichereinrichtungen weiter zu steigern.

Der Erfindung liegt die Aufgabe zugrunde, eine Grabenstrukturkondensatoreinrichtung sowie ein Verfahren zu deren Herstellung bereitzustellen, mit denen auch bei weiterer Verkleinerung der Dimensionierungen entsprechende Mindestkapazitäten auf einfache Art und Weise gewährleistet werden können.

Vorrichtungsmäßig wird die Aufgabe durch eine Kondensatoreinrichtung erfindungsgemäß durch die kennzeichnenden Merkmale des Anspruchs 1 oder des Anspruchs 3 gelöst. Verfahrensmäßig wird die Aufgabe bei einem Herstellungsverfahren erfindungsgemäß durch die kennzeichnenden Merkmale des Anspruchs 13 oder des Anspruchs 15 gelöst. Vorteilhafte Weiterbildungen der erfindungsgemäßen Kondensatoreinrichtung sowie des entsprechenden Herstellungsverfahrens sind jeweils Gegenstand der abhängigen Unteransprüche.

Gemäß den vorrichtungsmäßigen Lösungen der Aufgabe ist es erfindungsgemäß vorgesehen, dass in einem Halbleitersubstrat, einem Passivierungsbereich, Isolationsbereich und/oder Oberflächenbereich davon ein erster Elektrodenbereich und in im Wesentlichen direkter räumlicher Nachbarschaft dazu ein Dielektrikumsbereich ausgebildet sind, insbesondere in dieser Reihenfolge und/oder insbesondere in jeweils im Wesentlichen zusammenhängender Form.

Ferner ist es bei der ersten vorrichtungsmäßigen Lösung der Aufgabe erfindungsgemäß vorgesehen, dass zumindest der erste Elektrodenbereich zumindest zu einem Teil aus einem metallischen Material, einem Metallnitrid und/oder dergleichen ausgebildet ist oder ein solches Material aufweist.

Zusätzlich oder alternativ - gemäß der zweiten vorrichtungsmäßigen Lösung - zu diesem letzten Aspekt oder Merkmalskomplex ist es erfindungsgemäß vorgesehen, dass der Dielektrikumsbereich zumindest zum Teil aus einem Material mit einer, insbesondere gegenüber SiO₂, Si₃N₄ und/oder dergleichen, gesteigerten Dielektrizitätskonstante ausgebildet ist oder ein solches Material aufweist.

Diese beiden Maßnahmen können als alternative Lösungsvorschläge vorgesehen sein, sie können aber auch gemeinsam das erfindungsgemäße Konzept verwirklichen.

Durch die Erfindung werden somit zwei Maßnahmen gemeinsam oder alternativ vorgesehen und/oder verwirklicht, um die Kapazität der jeweiligen Kondensatoreinrichtung zu steigern. Die eine Maßnahme ist charakterisiert durch die Ausbildung zumindest des ersten Elektrodenbereichs als ein metallisches Material, ein Metallnitrid und/oder dergleichen. Die andere Maßnahme sieht die Ausbildung des Dielektrikumsbereichs aus einem Material mit gesteigerter Dielektrizitätskonstante vor.

Grundidee dabei ist in beiden Fällen, dass gegenüber herkömmlichen Kondensatoreinrichtungen die spezifische Kapazität der erzeugten Kondensatoreinrichtung gesteigert ist. Das bedeutet, dass pro Flächeneinheit des jeweiligen Elektrodenbereiches erfindungsgemäß eine gesteigerte Kapazität bereitgestellt werden kann.

Dies wird gemäß der ersten erfindungsgemäßen Lösung der Aufgabe dadurch erreicht, dass als Elektrodenmaterialien metallische Materialien, insbesondere Metalle, Metallnitride und/oder dergleichen verwendet werden. Herkömmlicherweise werden nämlich, gegebenenfalls dotierte, Halbleitermaterialien zur Ausbildung der Elektrodenbereiche eingesetzt. Diese gewöhnlichen Halbleitermaterialien, zum Beispiel Polysilizium oder dergleichen, besitzen aufgrund ihrer insbesondere elektronischen Struktur eine nur wenig auf Flächenbereiche, sondern vielmehr auf Raumbereiche verteilte Ladungsdichte, durch welche eine Raumladungszone gebildet wird. Demgegenüber bildet sich an metallischen Bereichen keine Raumladungszone, sondern im Wesentlichen eine flächenhafte Ladungsverteilung an der Oberfläche oder Grenzfläche der Elektrode aus. Entsprechend ergeben sich bei der Verwendung metallischer Elektroden geringe effektive Schichtdicken für das Dielektrikum, was eine bei vergleichsweise sich entsprechenden Elektrodenflächen höhere Kapazität bei den erfindungsgemäßen Kondensatoreinrichtungen bewirkt. Das heißt, es verringert sich bei der Verwendung von Metallelektroden die effektive Dicke des Dielektrikums um die Ausdehnung der dann fortfallenden Raumladungszone.

Bei der anderen erfindungsgemäßen Lösung ist es dagegen vorgesehen, das Dielektrikum mit einer vergleichsweise gesteigerten Dielektrikumskonstante auszubilden. Herkömmlicherweise werden Materialien wie Siliziumdioxid SiO₂, Siliziumnitrid Si₃N₄ und/oder dergleichen eingesetzt. Die Kapazität einer Kondensatoreinrichtung ist aber linear korreliert mit der Dielektrizitätskonstanten des zwischen den Elektrodenbereichen vorgesehenen Dielektrikums. Dementsprechend kann bei der Auswahl des entsprechenden Dielektrikumsmaterials ebenfalls die spezifische Kondensatorkapazität maßgeblich beeinflusst, also auch gesteigert werden.

Gemäß einer anderen Ausführungsform ist es vorgesehen, dass mindestens ein zweiter Elektrodenbereich, insbesondere in im Wesentlichen direkter räumlicher Nachbarschaft zum Dielektrikumsbereich, ausgebildet ist, welcher insbesondere zumindest zum Teil aus mindestens einem metallischen Material, einem Metallnitrid und/oder dergleichen besteht oder ein solches Material aufweist.

Bei einer besonders bevorzugten Ausführungsform der erfindungsgemäßen Kondensatoreinrichtung ist es vorgesehen, dass der erste Elektrodenbereich, der Dielektrikumsbereich und/oder zweite Elektrodenbereich jeweils schichtartig, insbesondere mehrschichtig, ausgebildet sind. Eine schichtartige Struktur für einen oder mehrere dieser Bereiche kann zum Beispiel im Hinblick auf die Kompatibilität mit den Umgebungsmaterialien oder bei der weiteren Steigerung der spezifischen Kapazität der auszubildenden Kondensatoreinrichtung vorteilhaft sein.

Es ist vor allem von besonderem Vorteil, wenn gemäß einer weiteren Ausführungsform der erfindungsgemäßen Kondensatoreinrichtung der erste Elektrodenbereich, der Dielektrikumsbereich und/oder der zweite Elektrodenbereich im Wesentlichen konform ausgebildet sind. Durch das konforme Ausbilden der jeweiligen Schichten oder Bereiche wird ein optimales Ausnutzen der auf dem Halbleitersubstrat, dem Passivierungsbereich und/oder dem Oberflächenbereich davon ausgebildeten Struktur in der dabei angebotenen Oberfläche erreicht. Um das Ausbilden von Leckströmen gering zu halten, wird oder ist das Dielektrikum vorteilhafterweise als im Wesentlichen konformer Bereich ausgebildet.

Es ist besonders vorteilhaft, wenn gemäß einer besonders bevorzugten Ausführungsform der erfindungsgemäßen Kondensatoreinrichtung der jeweilige Dielektrikumsbereich als physikalisch und/oder chemischer Umwandlungsbereich zumindest eines Teils des ersten Elektrodenbereichs ausgebildet ist, insbesondere als, vorzugsweise elektrochemischer, Oxidationsbereich und/oder dergleichen und/oder insbesondere in konformer Art und Weise.

Bei dieser Ausführungsform kommt gerade die Kombination der beiden erfindungsgemäßen Lösungen zum Tragen, nämlich das gleichzeitige Vorsehen eines metallischen Materials für den ersten Elektrodenbereich und eines in der Dielektrizitätskonstanten gesteigerten Materials für den Dielektrikumsbereich. Es bietet sich hier zum Beispiel an, durch einen entsprechenden Prozess den Dielektrikumsbereich zum Beispiel als Oxidationsschicht der ausgebildeten Metallschicht oder Metallnitridschicht des ersten Elektrodenbereichs vorzusehen. Durch dieses Vorgehen werden somit beide erfindungsgemäßen Lösungsgedanken realisiert, und gleichzeitig wird in vorteilhafter Art und Weise eine besonders stabile Struktur erreicht, weil der erste Elektrodenbereich und der Dielektrikumsbereich quasi einstückig miteinander verbunden sind.

Auch bei einem - vor Umwandlung - nicht konform ausgebildeten ersten Elektrodenbereich bildet sich in vorteilhafter Weise bei der Umwandlung im Wesentlichen konformer Dielektrikumsbereich aus.

Es ist von besonderem Vorteil, wenn der erste Elektrodenbereich und/oder der zweite Elektrodenbereich zumindest zum Teil gebildet sind aus Al, W, WN, Ta, TaN, Ti, TiN, Hf, HfN, Zr, ZrN, Mo, MoN, Y, YN, La, LaN, Ce, CeN und/oder dergleichen und/oder einer Kombination oder Verbindung davon.

Zusätzlich oder alternativ ist es weiter von Vorteil, wenn der Dielektrikumsbereich zumindest zum Teil gebildet ist aus Al₂O₃, TiO₂, Ta₂O₅, HfO₂, ZrO₂, WO₃, MoO₂, Y₂O₃, La₂O₃, CeO₂, MgO und/oder dergleichen und/oder einer Kombination oder Verbindung davon.

Vorteilhafterweise ist die Kondensatoreinrichtung als Grabenstrukturkondensatoreinrichtung, als Graben- oder Trenchkondensator ausgebildet.

Dabei ist es insbesondere vorgesehen, dass in einem Halbleitersubstrat, einem Passivierungsbereich, Isolationsbereich und/oder einem Oberflächenbereich davon, eine mindestens eine Ausnehmung oder einen Graben aufweisende Grabenstruktur ausgebildet ist, dass, insbesondere im jeweiligen Graben, der erste Elektrodenbereich, ggf. der zweite Elektrodenbereich und der im Wesentlichen dazwischen vorgesehene Dielektrikumsbereich, insbesondere in dieser Reihenfolge und/oder insbesondere in jeweils im Wesentlichen zusammenhängender Form, ausgebildet sind und dadurch, dass zumindest Wandbereiche oder Randbereiche und/oder Bodenbereiche des jeweiligen Grabens im Wesentlichen bedeckt und/oder ausgekleidet ausgebildet sind, zumindest zum Teil mit dem ersten Elektrodenbereich, ggf. mit dem zweiten Elektrodenbereich und/oder mit dem Dielektrikumsbereich.

Die verfahrensmäßigen Lösungen der Aufgaben stellen bereit ein Verfahren zur Herstellung einer Kondensatoreinrichtung für eine Halbleiterschaltungsanordnung und insbesondere für eine Halbleiterspeichereinrichtung, einen DRAM-Speicher oder dergleichen, bei welchem in einem Halbleitersubstrat, einem Passivierungsbereich, Isolationsbereich und/oder einem Oberflächenbereich davon eine Anordnung mit einem ersten Elektrodenbereich und einem in im Wesentlichen direkter räumlicher Nachbarschaft davon vorgesehenen Dielektrikumsbereich, insbesondere in dieser Reihenfolge und/oder insbesondere in jeweils im Wesentlichen zusammenhängender Form, ausgebildet wird.

Bei dem erfindungsgemäßen Verfahren zur Herstellung einer Kondensatoreinrichtung für eine Halbleiterschaltungsanordnung und insbesondere für eine Halbleiterspeichereinrichtung, ein DRAM-Speicher oder dergleichen, ist es gemäß einer ersten Lösung ferner vorgesehen, dass zumindest der erste Elektrodenbereich zumindest zu einem Teil aus mindestens einem metallischen Material, einem Metallnitrid und/oder dergleichen ausgebildet wird.

Alternativ - gemäß einer zweiten Lösung - oder zusätzlich ist es vorgesehen, dass der Dielektrikumsbereich zumindest zum Teil aus einem Material mit einer, insbesondere gegenüber SiO₂, Si₃N₄ und/oder dergleichen, gesteigerten Dielektrizitätskonstante gebildet wird.

In weiterer Analogie zu der vorrichtungsgemäßen Lösung der der Erfindung zugrundeliegenden Aufgabe ist es auch bei dem Herstellungsverfahren vorgesehen, die erste und/oder zweite Elektrodenbereiche zumindest zu einem Teil aus einem metallischen Material, einem Metallnitrid und/oder dergleichen auszubilden oder alternativ oder zusätzlich dazu das Dielektrikumsmaterial mit einer entsprechend gesteigerten Dielektrizitätskonstante auszubilden.

Durch jede der beiden Maßnahmen für sich und insbesondere durch deren Zusammenwirken werden Kondensatoreinrichtungen mit einer gegenüber herkömmlich hergestellten Kondensatoreinrichtungen gesteigerten spezifischen Kapazität realisierbar, die auch bei weiterer Miniaturisierung und Steigerung der Integrationsdichte noch eine ausreichende Kondensatorkapazität bereitstellen, um eine ausreichende Funktionalität gewährleisten zu können.

Auch hier können beide Maßnahmen getrennt oder in Zusammenwirken verfahrensmäßig angewandt werden.

Gemäß einer anderen Ausführungsform ist es vorgesehen, dass mindestens ein zweiter Elektrodenbereich, insbesondere in im Wesentlichen direkter räumlicher Nachbarschaft zum Dielektrikumsbereich, ausgebildet ist, welcher insbesondere zumindest zum Teil aus mindestens einem metallischen Material, einem Metallnitrid und/oder dergleichen besteht oder ein solches Material aufweist.

Bei einer besonders vorteilhaften Ausführungsform des erfindungsgemäßen Verfahrens ist es vorgesehen, dass der erste Elektrodenbereich, der Dielektrikumsbereich und/oder der zweite Elektrodenbereich jeweils schichtartig, insbesondere jeweils mehrschichtig, ausgebildet werden.

Bei einer weiteren vorteilhaften Ausführungsform des erfindungsgemäßen Herstellungsverfahrens ist es vorgesehen, dass der erste Elektrodenbereich, der Dielektrikumsbereich und/oder der zweite Elektrodenbereich jeweils im Wesentlichen isotrop, zweidimensional, konform, großflächig und/oder ganzflächig ausgebildet werden. Dadurch wird erreicht, dass, sollten bestimmte Ausheilungsschritte oder Weiterverarbeitungsschritte für die einzelnen Schichten notwendig sein, die zugrundeliegende Struktur des Halbleitersubstrats, des Passivierungsbereichs oder dergleichen im Wesentlichen geschützt vorliegen. Nach dem Ausbilden der entsprechenden Schichtstrukturen und deren Weiterverarbeitung kann dann ein entsprechendes Strukturieren, zum Beispiel durch selektive Ätzprozesse oder dergleichen erfolgen.

Vorteilhafterweise erfolgt das Ausbilden des ersten Elektrodenbereichs, des Dielektrikumsbereichs und/oder des zweiten Elektrodenbereichs jeweils durch Abscheiden, insbesondere durch ein CVD-Verfahren, durch ein ALD-Verfahren, durch ein elektrochemisches Umwandlungs- und/oder Abscheideverfahren und/oder dergleichen.

Von besonderem Vorteil ist es, dass gemäß einer weiteren Ausführungsform des erfindungsgemäßen Verfahrens zum Herstellen einer Grabenstrukturkondensatoreinrichtung zunächst der erste Elektrodenbereich ausgebildet wird. Gemäß dieser Ausführungsform wird dann nachfolgend der Dielektrikumsbereich durch physikalisches und/oder chemisches Umwandeln zumindest eines Teils des ersten Elektrodenbereichs ausgebildet. Dies geschieht insbesondere durch, vorzugsweise elektrochemisches, Oxidieren oder dergleichen und/oder insbesondere in konformer Art und Weise. Durch diese Maßnahme wird erreicht, dass beide erfindungsgemäßen Lösungsgedanken in einer integrierten Prozessabfolge aufgenommen sind. Zunächst wird dabei das metallisch auszubildende erste Elektrodenmaterial abgeschieden und dann nachfolgend zum Beispiel elektrochemisch behandelt, wodurch sich gerade ein Dielektrikumsbereich mit gegenüber herkömmlichen Materialien gesteigerter Dielektrizitätskonstante ergibt.

Bei einer besonders vorteilhaften Ausführungsform des erfindungsgemäßen Herstellungsverfahrens ist es vorgesehen, dass der erste Elektrodenbereich und/oder der zweite Elektrodenbereich zumindest zu einem Teil gebildet werden aus Al, W, WN, Ta, TaN, Ti, TiN, Hf, HfN, Zr, ZrN, Mo, MoN, Y, YN, La, LaN, Ce, CeN und/oder dergleichen und/oder einer Kombination oder Verbindung davon.

Es ist auch vorgesehen, dass der Dielektrikumsbereich zumindest zu einem Teil gebildet wird aus Al₂O₃, TiO₂, Ta₂O₅, HfO₂, ZrO₂, WO₃, MoO₂, Y₂O₃, La₂O₃, CeO₂, MgO und/oder dergleichen und/oder einer Kombination oder Verbindung davon.

Vorteilhafterweise wird die Kondensatoreinrichtung als Grabenstrukturkondensatoreinrichtung, als Graben- oder Trenchkondensator ausgebildet.

Dabei ist es insbesondere vorgesehen, dass in einem Halbleitersubstrat, einem Passivierungsbereich, Isolationsbereich und/oder einem Oberflächenbereich davon, eine mindestens eine Ausnehmung oder einen Graben aufweisende Grabenstruktur ausgebildet wird, dass, insbesondere im jeweiligen Graben, der erste Elektrodenbereich, ggf. der zweite Elektrodenbereich und der im Wesentlichen dazwischen vorgesehene Dielektrikumsbereich, insbesondere in dieser Reihenfolge und/oder insbesondere in jeweils im Wesentlichen zusammenhängender Form, ausgebildet werden und dass dabei zumindest Wandbereiche oder Randbereiche und/oder Bodenbereiche des jeweiligen Grabens im Wesentlichen bedeckt und/oder ausgekleidet ausgebildet werden, zumindest mit einem Teil des ersten Elektrodenbereichs, ggf. des zweiten Elektrodenbereichs und/oder des Dielektrikums.

Diese und weitere Aspekte der vorliegenden Erfindung werden anhand der nachstehenden Bemerkungen weiter erläutert:

In dynamischen Schreib-Lesespeichern, sogenannten DRAMs, werden heute sogenannte 1-Transistorzellen eingesetzt. Diese bestehen aus einem Speicherkondensator und einem Auswahltransistor, welcher die Speicherelektrode mit der Bitleitung verbindet. Der Speicherkondensator wird häufig als sogenannter Trenchkondensator oder Grabenkondensator ausgebildet. Das heißt, es werden ein Loch in das Substrat geätzt und ein Dielektrikum sowie eine Speicherelektrode eingebracht, wobei im Stand der Technik sogenanntes dotiertes Polysilizium verwendet wird. Als Gegenelektrode wird zur Zeit das dotierte Siliziumsubstrat, das sogenannte Buried Plate, verwendet.

Die hier beschriebene Erfindung bezieht sich insbesondere auf diesen Speichertyp, wobei Trenchspeicherkondensatoren oder sogenannte Grabenstrukturkondensatoreinrichtungen verwendet werden.

Um die Speicherdichte für zukünftige Technologiegenerationen weiter zu erhöhen, wird die Strukturgröße von Generation zu Generation verkleinert. Die immer kleiner werdenden Kondensatorflächen und die dadurch bedingte kleiner werdende Kondensatorkapazität führt zu Problemen im Hinblick auf die Funktionsverlässigkeit. Deshalb ist es ein wichtiges Ziel, die Kondensatorkapazität trotz kleiner werdender Strukturgröße mindestens konstant zu halten. Dies kann unter anderem durch eine Erhöhung der Flächenladungsdichte des Speicherkondensators erreicht werden. Eine weitere Möglichkeit zur Erhöhung der Kondensatorkapazität besteht in der Substitution der an das Dielektrikum angrenzenden Siliziumschichten durch metallische Schichten, welche keine für das Silizium typische Raumladungszone aufweisen.

Bisherige Lösungsversuche im Hinblick auf die obengenannten Probleme gehen von einer Vergrößerung der zur Verfügung stehenden Kondensatorfläche bei vorgegebener Strukturgröße aus. Dies kann zum Beispiel durch eine Aufweitung des Grabens oder Trenches, zum Beispiel nach dem Wet-Bottle-Prinzip unterhalb des Kragenbereichs oder Oxidkragens oder Collars oder durch die Abscheidung von Polysilizium mit rauher Oberfläche, zum Beispiel im sogenannten HSG-Verfahren, im Graben oder Trench erreicht werden.

Andererseits wurde konventionell bisher die Flächenladungsdichte durch eine Verringerung der Dicke des Dielektrikums erhöht. Dabei wurden bisher als Dielektrikumsmaterial für sogenannte Trenchkondensatoren oder Grabenstrukturkondensatoreinrichtungen ausschließlich verschiedene Kombinationen von Siliziumdioxid SiO₂ und Siliziumnitrid Si₃N₃ in Verbindung mit dotierten Siliziumelektroden verwendet. Eine weitere Verringerung der Dicke dieser Dielektrika ist aufgrund der dadurch auftretenden hohen Leckströme nicht möglich.

Die vorliegende Erfindung ermöglicht es, die Flächenladungsdichte durch die Verwendung neuer Dielektrika im Trenchkondensator mit im Vergleich zu bisher verwendeter Dielektrika höherer Dielektrizitätskonstante zu vergrößern, ohne dabei die Leckströme maßgeblich zu erhöhen. Die im Rahmen dieser Erfindung vorgeschlagenen Vorgehensweisen zeichnen sich insbesondere dadurch aus, dass zunächst ein metallischer Film bzw. eine Kombination metallischer Filme oder auch Metallnitride abgeschieden wird, um einen ersten oder unteren Elektrodenbereich zu bilden. Diese abgeschiedenen Schichten werden dann durch ein elektrochemisches Verfahren oxidiert. Die Abscheidung der metallischen Filme kann durch CVD, das heißt durch Chemical Vapor Deposition, durch ALD, d.h. durch Atomic Layer Deposition, durch elektrochemische Abscheidung und/oder dergleichen erfolgen.

Als Materialien kommen in Frage für die Elektrodenschichten Al, W, WN, Ta, TaN, Ti, TiN, Hf, HfN, Zr, ZrN, Mo, MoN, Y, YN, La, LaN, Ce, CeN oder ähnliche Materialien.

Als Materialien kommen in Frage für die dielektrische Schicht, insbesondere ausgebildet durch elektrochemische Oxidation des entsprechenden Metalls bzw. Metallnitrids der ersten Elektrodenbereichs Al₂O₃, TiO₂, Ta₂O₅, HfO₂, ZrO₂, WO₃, MoO₂, Y₂O₃, La₂O₃, CeO₂, MgO oder ähnliche Materialien.

Kerngedanken der vorliegenden Erfindung sind also zum einen die Verwendung neuer Dielektrika mit vergleichsweise hohen Dielektrizitätskonstanten und die Verwendung von metallischen Elektrodenschichten zur Vermeidung von Raumladungszonen.

Falls der Prozessfluss die Verwendung identischer Metalle für die Elektrode und für das Dielektrikum - dort als Oxid des Metalls - erlaubt, ist als Vorteil hervorzuheben, dass die Abscheidung nicht perfekt konform erfolgen muss, solange die elektrochemische Oxidation konform erfolgt. Eine nichtkonforme Abscheidung resultiert in einer nichtkonformen Metallelektrode was als wesentlich unkritischer zu bewerten ist als ein nichtkonform abgeschiedenes Dielektrikum.

Als ein Ausführungsbeispiel ist die Formierung einer metallischen Elektrodenschicht und eines Dielektrikums bei Abscheidung einer metallischen Schicht denkbar. Ungeachtet dessen ist auch die Abscheidung von zwei oder mehreren metallischen Schichten, entweder zur Erzeugung gemischter Dielektrika oder auch zur Verwendung verschiedener Metalle für die Elektroden, möglich. Nach Abscheidung einer ersten metallischen Schicht in einer Grabenstruktur für den Grabenkondensator wird eine teilweise elektrochemische Oxidation dieser Metallschicht durchgeführt. Die so entstehende Struktur kann dann mit einem anderen Metall oder mit Polysilizium als Gegenelektrode aufgefüllt werden.

Nachfolgend wird die vorliegende Erfindung schematisch anhand einer Zeichnung auf der Grundlage bevorzugter Ausführungsbeispiele näher erläutert.

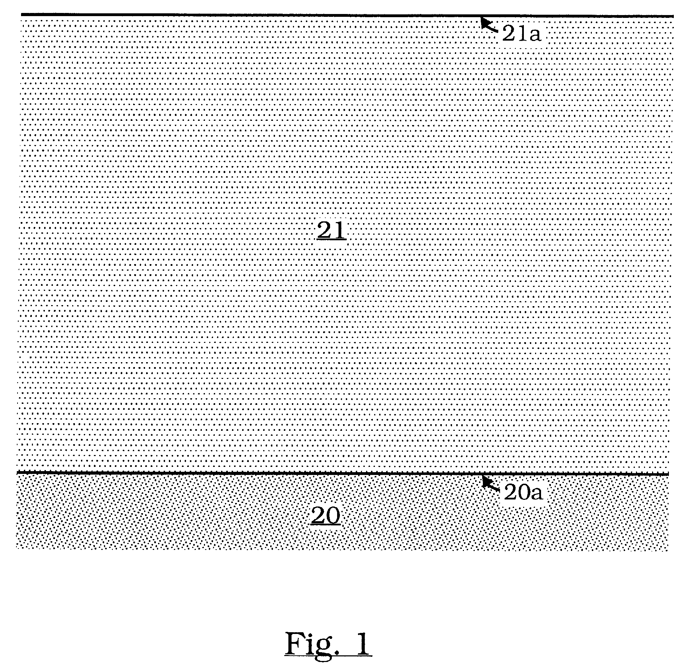

- Fig. 1 - 5: zeigen verschiedene Zwischenstufen, die beim erfindungsgemäßen Herstellungsverfahren einer erfindungsgemäßen Kondensatoreinrichtung im Fall eines Grabenkondensators erreicht werden.

Die nachfolgenden Fig. 1 bis 5 zeigen in schematischer und geschnittener Seitenansicht Zwischenstufen bei der erfindungsgemäßen Herstellung einer erfindungsgemäßen Kondensatoreinrichtung. Dabei bezeichnen identische Bezugszeichen die gleichen Elemente und Strukturen, eine jeweilige detaillierte Beschreibung erfolgt nicht in jedem Fall.

Ausgangspunkt für die Ausbildung einer erfindungsgemäßen Grabenstrukturkondensatoreinrichtung ist die in Fig. 1 gezeigte Grundstruktur, bei welcher auf einem ersten Substratbereich 20, z.B. einem ersten eigentlichen Halbleitersubstrat 20, mit im Wesentlichen planarem Oberflächenbereich 20a ein mit ebenfalls planarem Oberflächenbereich 21a ausgebildeter zweiter Substratbereich 21 vorgesehen ist, insbesondere ein zweites Halbleitersubstrat 21. Das erste Halbleitersubstrat 20 kann eine entsprechende zugrundeliegende CMOS-Struktur aufweisen. Die Substratbereiche 20 und 21 können auch einen einzigen, zusammenhängenden Substratbereich bilden.

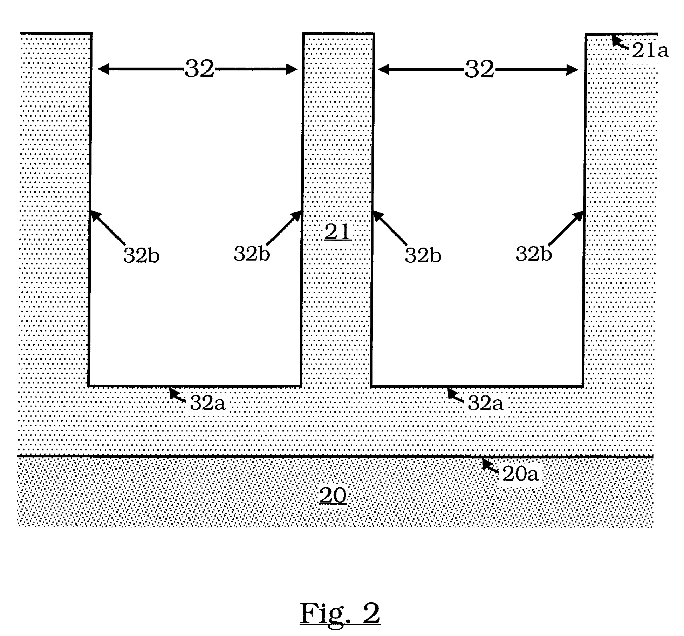

Im Übergang zu dem in Fig. 2 gezeigten Zwischenzustand wird durch einen entsprechenden Ätz- oder Lithografieschritt eine Grabenstruktur 30 im Halbleitersubstrat 21 bzw. dessen Oberflächenbereich 21a ausgebildet, welche in dem in Fig. 2 gezeigten Ausführungsbeispiel zwei Gräben 32 mit Wandbereichen 32b und jeweils einem Bodenbereich 32a besitzt.

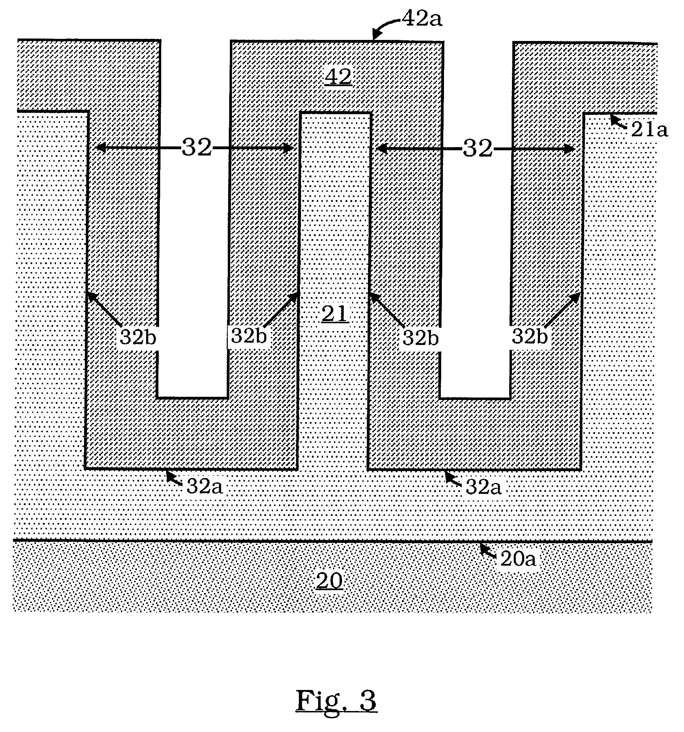

Im Übergang zu dem in Fig. 3 gezeigten Zwischenzustand wird dann ein Materialbereich 42 eines im Wesentlichen metallischen Materials ausgebildet. Dieser Materialbereich 42 ist als ein gemeinsamer Materialbereich für den auszubildenden ersten Elektrodenbereich 44 und den auszubildenden Dielektrikumsbereich 46 ausgelegt und besteht hier aus einem Metall, einem Metallnitrid oder dergleichen.

Die Abscheidung erfolgt, wie das in Fig. 3 gezeigt ist, in zweidimensionaler, ganzflächiger oder großflächiger und konformer Art und Weise, so dass die Gräben 32 der Grabenstruktur 30 und insbesondere der Wandbereiche 32b und Bodenbereiche 32a vorzugsweise in zusammenhängender und konformer Art und Weise bedeckt oder ausgekleidet sind.

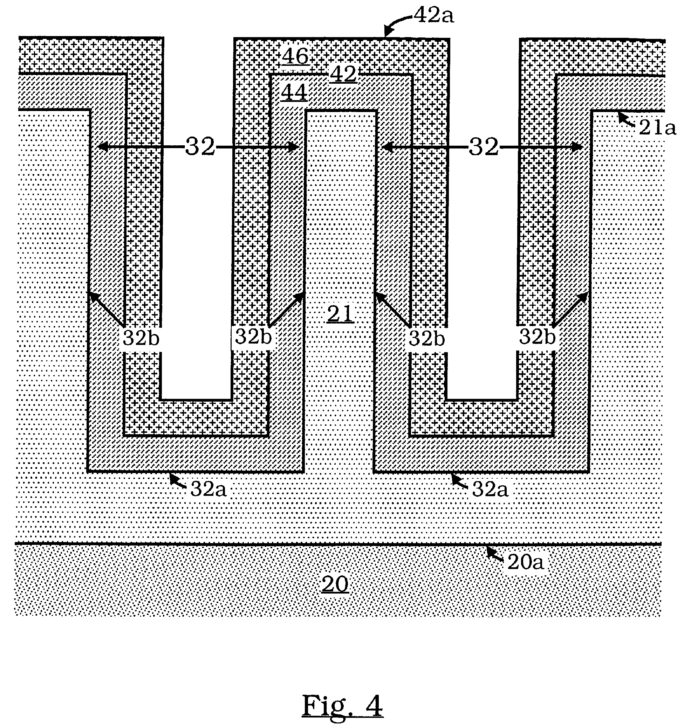

Im Übergang zum Zwischenzustand der Fig. 4 wird nun ein elektrochemischer Prozess auf die Struktur der Fig. 3 angewandt, so dass der Oberflächenbereich 42a der Materialschicht 42 elektrochemisch umgewandelt wird. Durch diese Vorgehensweise wird die Materialschicht 42 nunmehr in den ersten Elektrodenbereich 44 und den Dielektrikumsbereich 46 umgewandelt. Der erste Elektrodenbereich 44 und der darauffolgende Dielektrikumsbereich 46 sind somit in einstückiger Art und Weise miteinander verbunden.

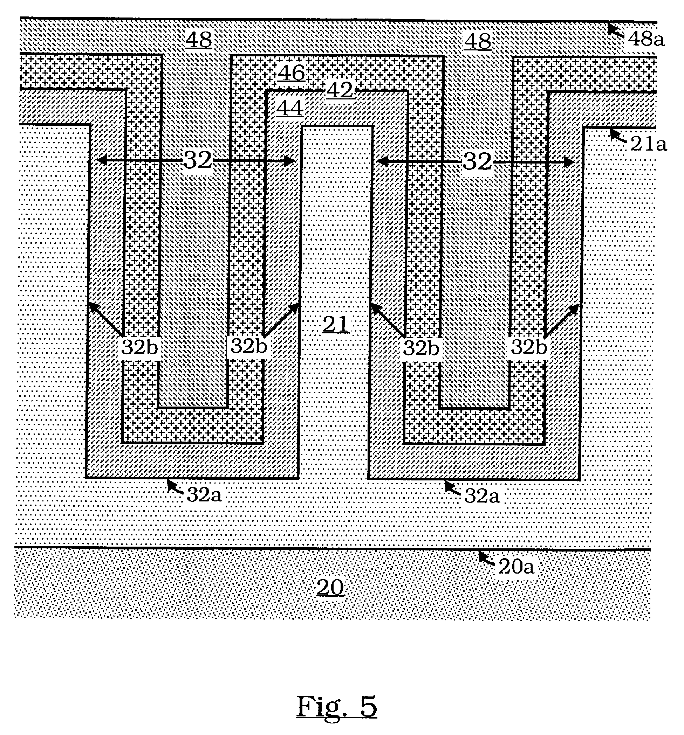

Im Übergang zu dem in Fig. 5 gezeigten Zwischenzustand wird dann die Grabenstrukturkondensatoreinrichtung 40 in erfindungsgemäßer Art und Weise fertiggestellt, indem in zweidimensionaler Art und Weise der zweite Elektrodenbereich 48 in Form einer metallischen Schicht derart abgeschieden wird, dass zum einen ein Oberflächenbereich 48a entsteht und zum anderen die bisher freigebliebenen Ausnehmungsbereiche der Gräben 32 der Grabenstruktur 30 zumindest teilweise gefüllt werden, so dass dort der Dielektrikumsbereich 46 vollständig vom zweiten Elektrodenbereich 48 bedeckt ist.

### Bezugszeichenliste

- 1: Halbleiterspeichereinrichtung
- 20: erster Substratbereich, Halbleitersubstrat
- 20a: Oberflächenbereich
- 21: zweiter Substratbereich, Halbleitersubstrat
- 21a: Oberflächenbereich
- 30: Grabenstruktur
- 32: Ausnehmung, Graben
- 32a: Bodenbereich
- 32b: Wandbereich, Randbereich
- 40: (Grabenstruktur-)Kondensatoreinrichtung
- 42: Materialbereich
- 42a: Oberflächenbereich
- 44: erster Elektrodenbereich
- 44a: Oberflächenbereich
- 46: Dielektrikumsbereich
- 46a: Oberflächenbereich
- 48: zweiter Elektrodenbereich
- 48a: Oberflächenbereich
- 50: Materialbereich
- 50a: Oberflächenbereich

## Patentansprüche

1. Kondensatoreinrichtung für eine Halbleiterschaltungsanordnung und insbesondere für eine Halbleiterspeichereinrichtung, für einen DRAM-Speicher oder dergleichen,
- bei welcher in einem Halbleitersubstrat (20, 21), einem Passivierungsbereich, Isolationsbereich und/oder einem Oberflächenbereich (20a, 21a) davon ein erster Elektrodenbereich (44) und in im Wesentlichen direkter räumlicher Nachbarschaft dazu ein Dielektrikumsbereich (46), insbesondere in dieser Reihenfolge und/oder insbesondere in jeweils im Wesentlichen zusammenhängender Form, ausgebildet sind und
- bei welcher zumindest der erste Elektrodenbereich (44) zumindest zu einem Teil aus mindestens einem metallischen Material, einem Metallnitrid und/oder dergleichen ausgebildet ist oder ein solches Material aufweist.

2. Kondensatoreinrichtung nach Anspruch 1,
**dadurch gekennzeichnet,**
**dass** der Dielektrikumsbereich (46) zumindest zum Teil aus einem Material mit einer, insbesondere gegenüber SiO₂, Si₃N₄ und/oder dergleichen, gesteigerten Dielektrizitätskonstante ausgebildet ist oder ein solches Material aufweist.

3. Kondensatoreinrichtung für eine Halbleiterschaltungsanordnung und insbesondere für eine Halbleiterspeichereinrichtung, für einen DRAM-Speicher oder dergleichen,
- bei welcher in einem Halbleitersubstrat (20, 21), einem Passivierungsbereich, Isolationsbereich und/oder einem Oberflächenbereich (20a, 21a) davon ein erster Elektrodenbereich (44) und in im Wesentlichen direkter räumlicher Nachbarschaft dazu ein Dielektrikumsbereich (46), insbesondere in dieser Reihenfolge und/oder insbesondere in jeweils im Wesentlichen zusammenhängender Form, ausgebildet sind, und
- bei welcher der Dielektrikumsbereich (46) zumindest zum Teil aus einem Material mit einer, insbesondere gegenüber SiO₂, Si₃N₄ und/oder dergleichen, gesteigerten Dielektrizitätskonstante ausgebildet ist.

4. Kondensatoreinrichtung nach Anspruch 3,
**dadurch gekennzeichnet,**
**dass** zumindest der erste Elektrodenbereich (44) zumindest zu einem Teil aus mindestens einem metallischen Material, einem Metallnitrid und/oder dergleichen ausgebildet ist oder ein solches Material aufweist.

5. Kondensatoreinrichtung nach einem der vorangehenden Ansprüche,
**dadurch gekennzeichnet,**
**dass** mindestens ein zweiter Elektrodenbereich (48), insbesondere in im Wesentlichen direkter räumlicher Nachbarschaft zum Dielektrikumsbereich (46), ausgebildet ist, welcher insbesondere zumindest zum Teil aus mindestens einem metallischen Material, einem Metallnitrid und/oder dergleichen besteht oder ein solches Material aufweist.

6. Kondensatoreinrichtung nach einem der vorangehenden Ansprüche,
**dadurch gekennzeichnet,**
**dass** der erste Elektrodenbereich (44), der Dielektrikumsbereich (46) und/oder der zweite Elektrodenbereich (48) schichtartig, insbesondere jeweils mehrschichtig, ausgebildet sind.

7. Kondensatoreinrichtung nach einem der vorangehenden Ansprüche,
**dadurch gekennzeichnet,**
**dass** der erste Elektrodenbereich (44), der Dielektrikumsbereich (46) und/oder der zweite Elektrodenbereich (48) jeweils im Wesentlichen konform ausgebildet sind.

8. Kondensatoreinrichtung nach einem der vorangehenden Ansprüche,
**dadurch gekennzeichnet,**
**dass** der Dielektrikumsbereich (46) als physikalisch-chemischer Umwandlungsbereich eines Teils des ersten Elektrodenbereichs (44) ausgebildet ist, insbesondere als Oxidationsbereich davon und/oder dergleichen.

9. Kondensatoreinrichtung nach einem der vorangehenden Ansprüche,
**dadurch gekennzeichnet,**
**dass** der erste Elektrodenbereich (44) und/oder der zweite Elektrodenbereich (48) zumindest zum Teil ausgebildet sind aus Al, AlN, W, WN, Ta, TaN, Ti, TiN, Hf, HfN, Zr, ZrN, Mo, MoN, Y, YN, La, LaN, Ce, CeN und/oder dergleichen und/oder einer Kombination oder Verbindung davon.

10. Kondensatoreinrichtung nach einem der vorangehenden Ansprüche,
**dadurch gekennzeichnet,**
**dass** der Dielektrikumsbereich (46) zumindest zum Teil ausgebildet ist aus Al₂O₃, TiO₂, Ta₂O₅, HfO₂, ZrO₂, WO₃, MoO₂, Y₂O₃, La₂O₃, CeO₂, MgO und/oder dergleichen und/oder einer Kombination oder Verbindung davon.

11. Kondensatoreinrichtung nach einem der vorangehenden Ansprüche,
**dadurch gekennzeichnet,**
**dass** die Kondensatoreinrichtung als Grabenstrukturkondensatoreinrichtung oder dergleichen ausgebildet ist.

12. Kondensatoreinrichtung nach Anspruch 11,
**dadurch gekennzeichnet,**
- **dass** in einem Halbleitersubstrat (20, 21), einem Passivierungsbereich, Isolationsbereich und/oder einem Oberflächenbereich (20a, 21a) davon, eine mindestens eine Ausnehmung (32) oder einen Graben (32) aufweisende Grabenstruktur (30) ausgebildet ist,
- **dass**, insbesondere im jeweiligen Graben (32), der erste Elektrodenbereich (44), ggf. der zweite Elektrodenbereich (48) und der im Wesentlichen dazwischen vorgesehene Dielektrikumsbereich (46), insbesondere in dieser Reihenfolge und/oder insbesondere in jeweils im Wesentlichen zusammenhängender Form, ausgebildet sind und
- **dass** dadurch zumindest Wandbereiche (32b) oder Randbereiche (32b) und/oder Bodenbereiche (32a) des jeweiligen Grabens (32) im Wesentlichen bedeckt und/oder ausgekleidet ausgebildet sind, zumindest mit einem Teil des ersten Elektrodenbereichs (44), ggf. des zweiten Elektrodenbereichs (48) und/oder des Dielektrikumsbereichs (46).

13. Verfahren zur Herstellung einer Kondensatoreinrichtung für eine Halbleiterschaltungsanordnung und insbesondere für eine Halbleiterspeichereinrichtung, einen DRAM-Speicher oder dergleichen, insbesondere nach einem der Ansprüche 1 bis 12,
- bei welchem in einem Halbleitersubstrat (20, 21), einem Passivierungsbereich, Isolationsbereich und/oder einem Oberflächenbereich (20a, 21a) davon eine Anordnung (40) mit einem ersten Elektrodenbereich (44) und mit einem in im Wesentlichen direkter räumlicher Nachbarschaft davon vorgesehenen Dielektrikumsbereich (46), insbesondere in dieser Reihenfolge und/oder insbesondere in jeweils im Wesentlichen zusammenhängender Form, ausgebildet wird, und
- bei welchem der erste Elektrodenbereich (44) zumindest zu einem Teil mit oder aus mindestens einem metallischen Material, einem Metallnitrid und/oder dergleichen ausgebildet wird.

14. Verfahren nach Anspruch 13,
**dadurch gekennzeichnet,**
**dass** der Dielektrikumsbereich (46) zumindest zum Teil aus einem Material mit einer, insbesondere gegenüber SiO₂, Si₃N₄ und/oder dergleichen, gesteigerten Dielektrizitätskonstante gebildet wird.

15. Verfahren zur Herstellung einer Kondensatoreinrichtung für eine Halbleiterschaltungsanordnung und insbesondere für eine Halbleiterspeichereinrichtung, einen DRAM-Speicher oder dergleichen, insbesondere nach einem der Ansprüche 1 bis 12,
- bei welchem in einem Halbleitersubstrat (20, 21), einem Passivierungsbereich, Isolationsbereich und/oder einem Oberflächenbereich (20a, 21a) davon eine Anordnung (40) mit einem ersten Elektrodenbereich (44) und mit einem in im Wesentlichen direkter räumlicher Nachbarschaft davon vorgesehenen Dielektrikumsbereich (46), insbesondere in dieser Reihenfolge und/oder insbesondere in jeweils im Wesentlichen zusammenhängender Form, ausgebildet wird, und
- bei welchem zumindest der Dielektrikumsbereich (46) zumindest zum Teil aus einem Material mit einer, insbesondere gegenüber SiO₂, Si₃N₄ und/oder dergleichen, gesteigerten Dielektrizitätskonstante gebildet wird.

16. Verfahren nach Anspruch 15,
**dadurch gekennzeichnet,**
**dass** zumindest der erste Elektrodenbereich (44) zumindest zu einem Teil mit oder aus mindestens einem metallischen Material, einem Metallnitrid und/oder dergleichen ausgebildet wird.

17. Verfahren nach einem der Ansprüche 13 bis 16,
**dadurch gekennzeichnet,**
**dass** mindestens ein zweiter Elektrodenbereich (48), insbesondere in im Wesentlichen direkter räumlicher Nachbarschaft zum Dielektrikumsbereich (46) ausgebildet wird, insbesondere derart, dass dieser zumindest zum Teil aus mindestens einem metallischen Material, einem Metallnitrid und/oder dergleichen besteht oder ein solches Material aufweist.

18. Verfahren nach einem der Ansprüche 13 bis 17,
**dadurch gekennzeichnet,**
**dass** der erste Elektrodenbereich (44), der Dielektrikumsbereich (46) und/oder der zweite Elektrodenbereich (48) schichtartig, insbesondere jeweils mehrschichtig, ausgebildet werden.

19. Verfahren nach einem der Ansprüche 13 bis 18,
**dadurch gekennzeichnet,**
**dass** der erste Elektrodenbereich (44), der Dielektrikumsbereich (46) und/oder der zweite Elektrodenbereich (48) jeweils im Wesentlichen isotrop, zweidimensional, konform, großflächig und/oder ganzflächig ausgebildet werden.

20. Verfahren nach einem der Ansprüche 13 bis 19,
**dadurch gekennzeichnet,**
**dass** der erste Elektrodenbereich (44), der Dielektrikumsbereich (46) und/oder der zweite Elektrodenbereich (48) jeweils durch Abscheiden, durch ein CVD-Verfahren, durch ein ALD-Verfahren, durch ein elektrochemisches Umwandlungsund/oder Abscheideverfahren und/oder dergleichen ausgebildet werden.

21. Verfahren nach einem der Ansprüche 13 bis 20,
**dadurch gekennzeichnet,**
- **dass** zunächst der erste Elektrodenbereich (44) ausgebildet wird und
- **dass** dann der Dielektrikumsbereich (46) durch physikalisches und/oder chemisches Umwandeln zumindest eines Teils des ersten Elektrodenbereichs (44) ausgebildet wird, insbesondere durch, vorzugsweise elektrochemisches, Oxidieren oder dergleichen und/oder insbesondere in konformer Art und Weise.

22. Verfahren nach einem der Ansprüche 13 bis 21,
**dadurch gekennzeichnet,**
**dass** der erste Elektrodenbereich (44) und/oder der zweite Elektrodenbereich (48) zumindest zum Teil gebildet werden aus Al, W, WN, Ta, TaN, Ti, TiN, Hf, HfN, Zr, ZrN, Mo, MoN, Y, YN, La, LaN, Ce, CeN und/oder dergleichen und/oder einer Kombination oder Verbindung davon.

23. Verfahren nach einem der Ansprüche 13 bis 22,
**dadurch gekennzeichnet,**
**dass** der Dielektrikumsbereich (46) zumindest zum Teil gebildet wird aus Al₂O₃, TiO₂, Ta₂O₅, HfO₂, ZrO₂, WO₃, MoO₂, Y₂O₃, La₂O₃, CeO₂, MgO und/oder dergleichen und/oder einer Kombination oder Verbindung davon.

24. Verfahren nach einem der Ansprüche 13 bis 23,
**dadurch gekennzeichnet,**
**dass** die Kondensatoreinrichtung als Grabenstrukturkondensatoreinrichtung oder dergleichen ausgebildet wird.

25. Verfahren nach Anspruch 24,
**dadurch gekennzeichnet,**
- **dass** in einem Halbleitersubstrat (20, 21), einem Passivierungsbereich, Isolationsbereich und/oder einem Oberflächenbereich (20a, 21a) davon, eine mindestens eine Ausnehmung (32) oder einen Graben (32) aufweisende Grabenstruktur (30) ausgebildet wird,
- **dass** zumindest im Bereich des Grabens (32) eine Anordnung (40) mit dem ersten Elektrodenbereich (44), ggf. dem zweiten Elektrodenbereich (48) und dem im Wesentlichen dazwischen vorgesehenen Dielektrikumsbereich (46), insbesondere in dieser Reihenfolge und/oder insbesondere in jeweils im Wesentlichen zusammenhängender Form, ausgebildet wird und
- **dass** dabei zumindest Wandbereiche (32b) oder Randbereiche (32b) und/oder Bodenbereiche (32a) des jeweiligen Grabens (32) im Wesentlichen bedeckt und/oder ausgekleidet ausgebildet werden, zumindest mit einem Teil des ersten Elektrodenbereichs (44), ggf. des zweiten Elektrodenbereichs (48) und/oder des Dielektrikumsbereichs (46).
